# EUROPEAN PATENT APPLICATION

(11) **EP 1 394 835 A1**
(43) Date of publication of application: **03.03.2004**
(21) Application number: 02425536.6
(22) Date of filing: 29.08.2002
(51) Int. Cl.: H01J 37/32

(54) **A method and apparatus for detecting a leak of external air into a plasma reactor**

(71) Applicant: STMicroelectronics S.r.l., 20041 Agrate Brianza (Milano) (IT)
(72) Inventor: Ciovacco, Francesco, 20159 Milano (IT); Somboli, Fabio, 24040 Boltiere (BG) (IT); Fazio, Giuseppe, 20065 Inzago (MI) (IT); Alba, Simone, 20138 Milano (IT)
(74) Representative: Pezzoli, Ennio

(57) **Abstract**

A method (300) and a corresponding apparatus for detecting a leak of external air into a plasma reactor are proposed. The method of the invention includes the steps of: establishing (340) a plasma inside the reactor, the plasma having a composition suitable to generate at least one predetermined compound when reacting with the air, detecting (345) a light emission of the plasma, and analyzing (350-375) the light emission to identify the presence of the at least one predetermined compound.

## Description

The present invention relates to a method and a corresponding apparatus for detecting a leak of external air into a plasma reactor.

Plasma reactors are commonly used in several applications; for example, etching and deposition processes for the manufacturing of integrated circuits are often carried out exploiting plasma-based techniques. The plasma is a gas at very low pressure, to which a high electromagnetic field is applied so as to cause its ionization. The plasma reacts with a wafer of semiconductor material placed in the reactor, thereby performing the desired operation on the wafer.

A problem of plasma reactors is that a leak of external air may cause the introduction of undesired constituents into the plasma. These constituents adversely affect the chemical properties of the plasma, and then impair the characteristics of the resulting products. The problem is particular acute in a high precision process, wherein even a small leak of air may strongly reduce the yield of the process.

It is then of the utmost importance to monitor the amount of air leaking into the reactor. This activity ensures that the reactor always operates according to its specifications. Moreover, detection of a leak of air above the average (indicative of a deterioration generally increasing in the short time) allows the reactor to be fixed in advance.

For this purpose, a leak rate test is commonly carried out on the reactor. This test measures the increase of pressure with time in the evacuated reactor. The increase of pressure (known as pressure rate of rise) must be below a maximum allowable value; for example, a typical maximum allowable value is 2mtorr/min, corresponding to an air leakage of 0.03sccm (standard cubic centimeter per minute) in a chamber with a volume of about 35 liters.

However, the leak rate test takes a quite long time (5-10 minutes). This test requires the reactor to be completely idle; therefore, its operation must be temporarily suspended. Moreover, a technician is always needed to verify the reliability of the test (since it is sometimes difficult to ascertain whether a particular pressure rate of rise is due to a real leak of air or instead to the continued degassing of the reactor). As a consequence, the leak rate test can be performed only periodically and with a very low frequency (for example, every week); it is then possible for the reactor to run for a long time with an undetected leak of air (resulting in a high number of wafers to be ruined).

Alternative tests exploiting Optical Emission Spectroscopy (OES) techniques have also been proposed. These tests are based on the fact that the plasma emits light having a spectral pattern dependent on its composition; the leak of air is then determined in real time by monitoring the emission spectrum of the plasma.

For example, document US-A-5326975 discloses a method for estimating the amount of nitrogen (a particular constituent of the air) leaking into the reactor. Incremental known amounts of nitrogen are purposely introduced into the reactor; the intensity of respective emission peaks at a wavelength characteristic of the nitrogen are measured. A regression analysis of a curve plotting the intensity of the emission peaks against the known amounts of nitrogen is performed; the resulting curve is approximated by a quadratic relationship. This relationship is then solved for the intensity of the emission peak equal to zero, so as to obtain the unknown amount of nitrogen originally leaking into the chamber.

The method described above is very complex and must be reiterated several times for calibrating the increments of nitrogen to be introduced into the reactor. Moreover, the proposed algorithm is quite inaccurate. As a consequence, the use of the method is suggested only for detecting the leakage of a high amount of air into the reactor (for example, in gas lines supplying a process chamber).

A different solution is disclosed in document US-A-5789754. In this case, the intensity of an emission peak characteristic of a constituent of the air (such as oxygen) is compared with the intensity of an emission peak characteristic of a constituent of the plasma (such as argon) . An alarm is generated whenever the ratio of the two intensities exceeds a predetermined threshold value.

A drawback of the solution described above is that the proposed method has a very low sensibility. Experimental results have shown that even a significant leak of air into the reactor does not produce any perceivable change in the emission spectrum of the plasma. Therefore, the proposed method is unsuitable for monitoring operation of reactors used in high precision processes, wherein the amount of air leaking into the reactor must be maintained below a very low value.

It is an object of the present invention to overcome the above-mentioned drawbacks. In order to achieve this object, a method as set out in the first claim is proposed.

Briefly, the present invention provides a method of detecting a leak of external air into a plasma reactor including the steps of: establishing a plasma inside the reactor, the plasma having a composition suitable to generate at least one predetermined compound when reacting with the air, detecting a light emission of the plasma, and analyzing the light emission to identify the presence of the at least one predetermined compound.

Moreover, the present invention provides a computer program for performing the method and a product storing the program. The invention also encompasses a corresponding apparatus for detecting a leak of external air into a plasma reactor and a system including the apparatus.

Further features and the advantages of the solution according to the present invention will be made clear by the following description of a preferred embodiment thereof, given purely by way of a non-restrictive indication, with reference to the attached figures, in which:
Figure 1 is a pictorial representation of a system wherein the method of the invention can be used;
Figure 2 shows a schematic block diagram of a computer included in the system;
Figures 3a-3b are a flow chart describing the logic of a method for detecting a leak of air into a plasma reactor of the system; and
Figures 4a and 4b depict different emission spectra used in the method of the invention and in a method known in the art, respectively, for detecting the leak of air.

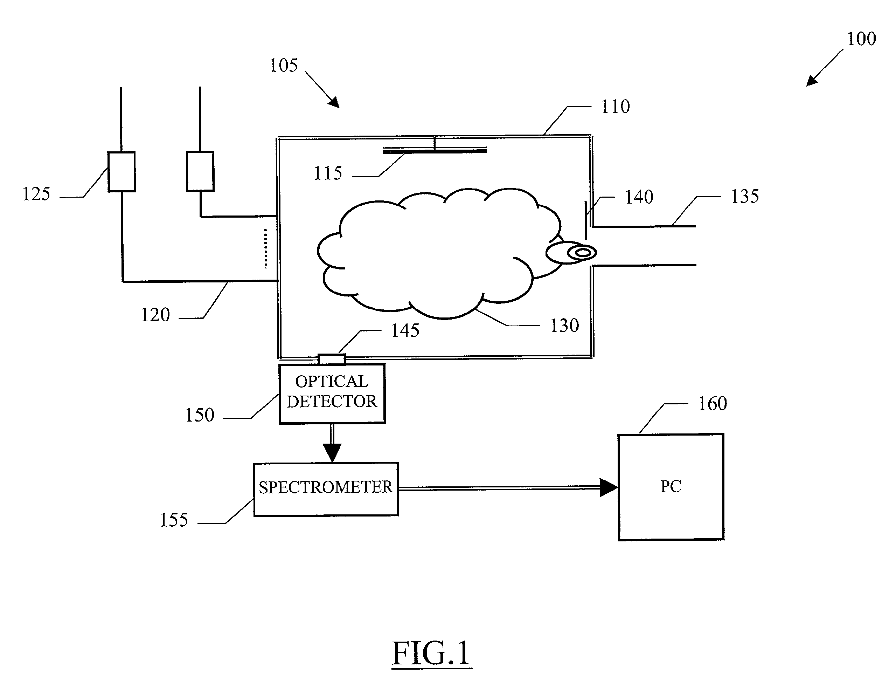

With reference in particular to Figure 1, a system 100 for detecting a leak of air into a plasma reactor 105 is illustrated. The reactor 105 includes an airtight process chamber 110; an electrode 115 (typically taken at a reference voltage, or ground) is provided inside the chamber 110 for housing a wafer of semiconductor material (not shown in the figure). A set of gas lines 120, each one with a corresponding mass flow controller 125, is used to introduce desired amounts of different gases into the chamber 110.

The gas inside the chamber 110 is kept at very low pressure (for example, in the range from 1mtorr to 500mtorr). A high electromagnetic field is then applied so as to cause the ionization of the gas; for this purpose, the chamber 110 includes a source power (or TCP) and a further electrode to which a radio-frequency biasing voltage is applied. This results in the generation of plasma 130, which includes positive and negative ions, neutral radicals, free electrons and different compounds obtained from the combination of the original constituents of the gas. The plasma 130 reacts with the wafer placed on the electrode 115; for example, in an etching process the reaction of the plasma 130 with a superficial layer of the wafer (such as polysilicon) generates corresponding volatile compounds. The plasma 130 (with the volatile compounds) is then removed through an outlet 135, which is connected to a pumping system (not shown in the figure); a gate valve 140 is used to close the outlet 135.

In addition, the plasma 130 generates a glow discharge. In fact, the electrons of several constituents of the plasma 130 are in an exited state; therefore, the exited electrons emit lights as they return to the respective fundamental energetic state. The light emitted by the plasma 130 has a spectral pattern dependent on its composition, pressure, power applied through the electromagnetic field, flow of the gas introduced in the chamber, and so on. Particularly, some of the constituents of the plasma 130 feature a spectral peak at specific wavelengths associated thereto; the intensity of the emission peak is indicative of the amount of the constituent that is present in the plasma 130.

The light passes through a viewing window 145, which is in communication with an optical detector 150. The optical detector 150 interfaces with a spectrum analyzer (spectrometer) 155. The spectrometer 155 supplies an emission spectrum (plotting the intensity of the light at different wavelengths) to a Personal Computer (PC) 160.

The computer 160 controls operation of the reactor 105; for this purpose, the computer 160 drives a set of actuators (not shown in the figure), which are used to automate operation of the reactor 105. Particularly, the computer 160 manages execution of different jobs, each one including a series of process steps to be carried out on a batch of wafers. The emission spectrum is commonly used to detect an endpoint of each process step. For example, in the etching of a superficial layer formed over an underlying layer the analysis of the emission spectrum makes it possible to determine if the etching is being to penetrate into the underlying layer (and then the process step is completed); for this purpose, the emission spectrum is monitored to ascertain when the compounds corresponding to the superficial layer begin to decrease and the compounds corresponding to the underlying layer begin to increase. As described in detail in the following, the computer 160 also exploits the emission spectrum to detect a leak of atmospheric gases, or air, into the reactor 100 (for example, through the chamber 110 and/or the gas lines 120).

Similar considerations apply if the reactor has a different structure or is used in other applications, such as in a oxide etching, in a metal etching, or in a Chemical Vapor Deposition (CVD) process, if the emission spectrum is detected with a different instrumentation, if the computer is replaced with equivalent means, and the like.

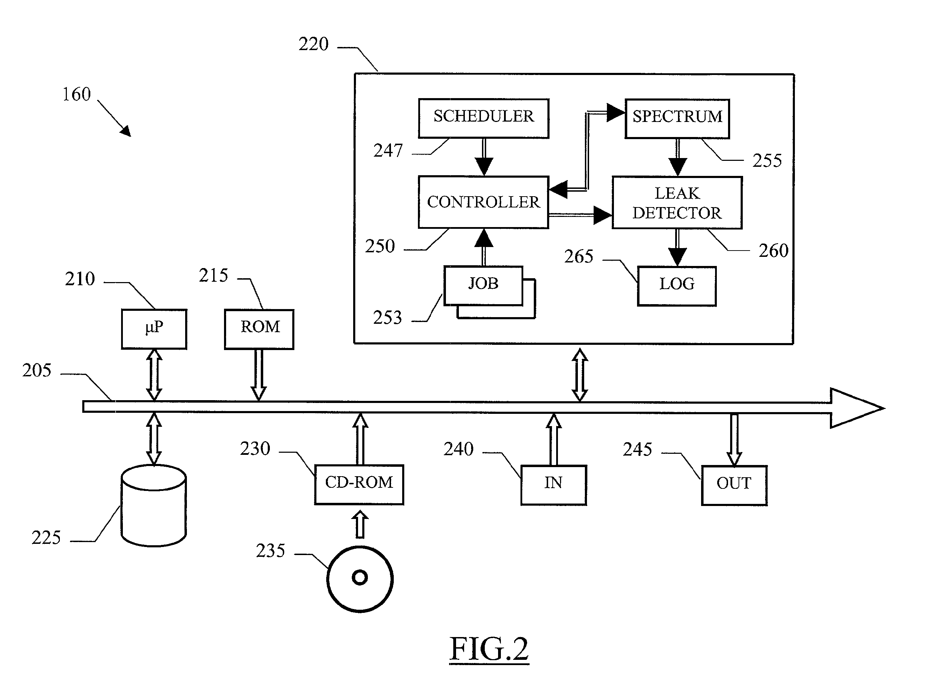

As shown in Figure 2, the computer 160 is formed by several units that are connected in parallel to a communication bus 205. In detail, a microprocessor (µP) 210 controls operation of the computer 160, a Read Only Memory (ROM) 215 stores basic code for a bootstrap of the computer 160, and a DRAM 220 is directly used as a working memory by the microprocessor 210. Several peripheral units are further connected to the bus 205. Particularly, a mass memory consists of a magnetic hard-disk 225 and a driver 230 for reading CD-ROMs 235. The computer 160 also includes input devices 240 and output devices 245. More specifically, the computer 160 is provided with general-purpose I/O devices, such as a keyboard, a mouse, a monitor and a pair of loudspeakers; the computer 160 is also provided with dedicated I/O devices, such as an interface for the spectrometer and a set of controllers for the actuators used to automate operation of the reactor.

The figure also depicts the main software components running on the computer 160. The information (programs and data) is typically stored on the hard-disk 225 and loaded (at least partially) into the working memory 220 when the programs are running, together with an operating system and other application programs (not shown in the figure). The programs are initially installed onto the hard-disk 225 from the CD-ROM 235.

A module 247 schedules execution of different jobs in the reactor. The scheduler 247 interfaces with a module 250, which controls each job on the basis of its definition stored in a corresponding file 253. The controller 250 drives the actuators of the reactor according to the process steps defined in the job under execution; a memory structure 255 is used to store the current emission spectrum of the plasma inside the reactor, which emission spectrum is monitored to determine the endpoint of each process step. The controller 250 also drives a module 260 handling the execution of a test for detecting any leak of air into the reactor. The leak detector 260 exploits the emission spectrum stored in the memory structure 255; the result of each test carried out on the reactor is saved in a log 265.

Similar considerations apply if the computer has a different structure or includes other units (such a printer and a network interface card), if the computer is replaced with an equivalent data processing system, if the programs are provided on any other computer readable medium (for example, one or more floppy-disks), if the programs and data are structured in a different manner, if other functions are provided, and the like.

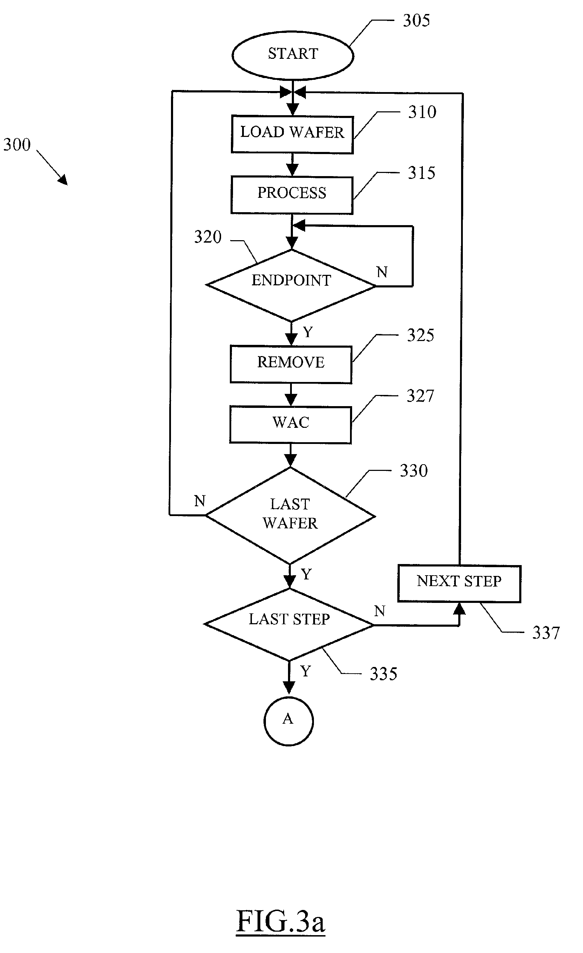

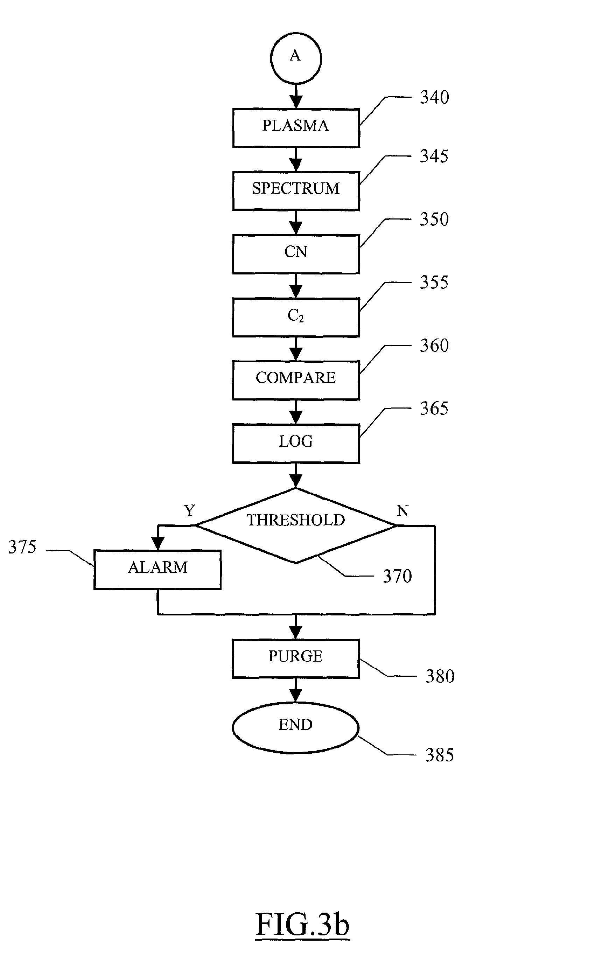

Moving now to Figures 3a-3b, the execution of each job implements a method 300 starting at block 305. Proceeding to block 310, a wafer of a batch to be processed is loaded into the chamber of the reactor. The method then passes to block 315, wherein the controller triggers execution of a current process step defined in the job (starting from the first one). An idle loop is entered at block 320, waiting for the endpoint of the current process step. As soon as the process step has been completed, the wafer is removed from the chamber at block 325. A Waferless AutoClean (WAC) process is then carried out at block 327. This process is used to remove any residue of the previous process steps from the chamber (and particularly from its internal walls); for example, the cleaning process removes polymeric material including C, N and H based compounds that are commonly formed when the volatile compounds resulting from the etching of a resist layer adhere to the internal walls of the chamber.

A test is made at decision block 330 to determine whether the last wafer of the batch has been processed. If not, the method returns to block 310 for repeating the operations described above on a next wafer. Conversely, the method verifies at block 335 whether the last process step of the job has been executed. If not, the next process step is selected at block 337, and the method returns to block 310. As soon as the job has been completed, the method descends into block 340.

Considering now block 340, a specific kind of plasma (referred to as host plasma) is established inside the chamber of the reactor. The host plasma is fluorocarbon or hydrocarbon based (i.e., it is generated from a gas including a compound with the general formula CxHyFz, wherein x,y,z are integer with x>=1 and y,z>=0); preferably, the host plasma includes CF₄ or CH₄. This composition facilitates the reaction of the host plasma with the constituents of the air, and particularly with nitrogen (N₂) ; the reaction results in the generation of one or more compounds (such as CN) featuring a very high intensity of their characteristic emission peaks. Preferably, several operative parameters of the reactor are optimized so as to maximize the intensity of the CN emission peak. For example, the host plasma is obtained from a gas flow between 20sccm and 80sccm of CF₄; the host plasma is established applying a pressure in the range from 50mtorr to 110mtorr and a source power in the range from 400W to 600W (with the biasing voltage equal to 0V, since no wafer is loaded in the chamber). Preferably, the host plasma is generated with 50sccm of CF₄, a pressure of 80mtorr and a source power of 500W.

After a few seconds (for example, 10-20s), the emission spectrum of the plasma is detected at block 345. This waiting time ensures that a corresponding transient phase (taking a few seconds) has been completed; therefore, the emission spectrum is stable and can be analyzed with high accuracy. The method then passes to block 350, wherein the intensity of the emission peak at 388nm wavelength is measured; this wavelength is characteristic of the compound CN, which is formed very easily (from the reaction of the host plasma with nitrogen) even when a small amount of air leaks into the chamber. The intensity of the emission peak at 516nm wavelength is likewise measured at block 355; this wavelength is instead characteristic of the compound C₂, which is a constituent of the host plasma independent of any leak of air.

Proceeding to block 360, the intensity of the CN emission peak is compared with the intensity of the C₂ emission peak. The resulting ratio of the two intensities gives an indication of the relative amount of the compound CN with respect to the host plasma, and then also of the leak of air into the reactor. This ratio is independent of the characteristics of the reactor (such as the transmittance of the viewing window or the optical alignment of the instrumentation) and it does not change with time (for example, with the fogging of the window); moreover, the ratio is calculated without any wafer in the reactor, so that its value is also independent of any process characteristics.

The ratio is logged on the computer at block 365. A test is made at decision block 370 to determine whether the ratio reaches a predetermined threshold value indicative of the maximum leak of air allowed in the reactor. Preferably, the threshold value is determined purposely introducing an amount of air into the chamber corresponding to the maximum allowed leakage, and then calculating the ratio between the intensity of the CN peak and the intensity of the C₂ peak in the resulting emission spectrum; for example, the threshold value corresponding to a leakage of 2mtorr/min is generally in the range from 0.8 to 1.5. If the result of the test carried out at block 370 is negative (ratio below the threshold value), the method descends into block 380 (described in the following). Conversely, the leak of air is outside the specifics of the reactor; in this case, an alarm is actuated at block 375 (for example, generating a buzz with the loudspeakers of the computer). The method then continues to block 380. Considering now block 380, the host plasma is removed from the reactor. The operation takes a few seconds (for example, 10-20s); as soon as the reactor has been purged, the method ends at the final block 385.

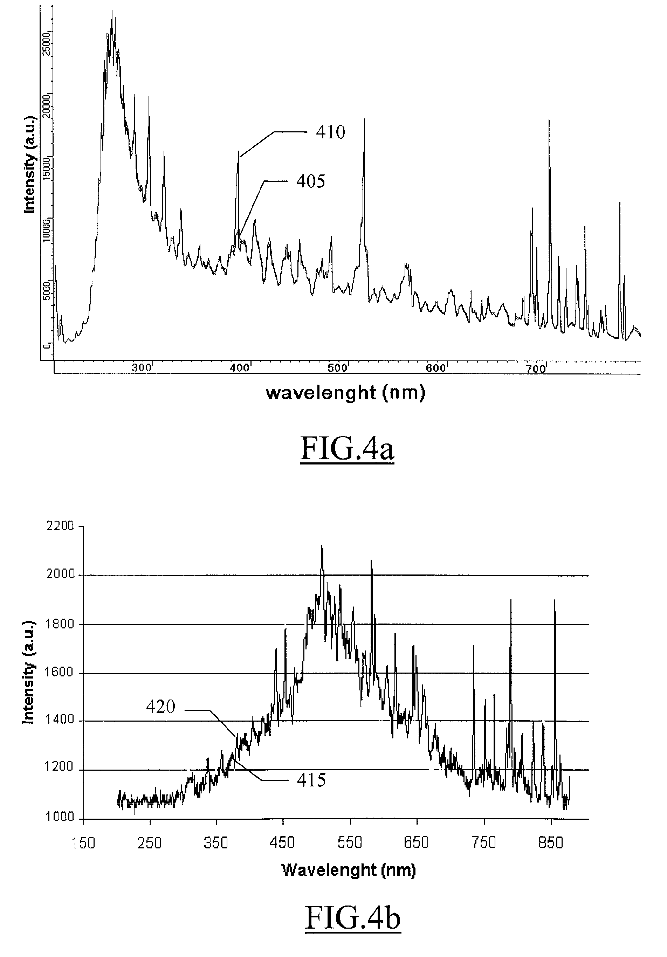

As shown in Figure 4a, an example of the emission spectrum obtained from the host plasma described above with substantially no leak of air is denoted with 405. Accordingly, the emission spectrum 405 has a pattern only corresponding to the constituents of the host plasma; particularly, the intensity of the emission peak at 516nm is indicative of the amount of the compound C₂ in the host plasma.

Conversely, if a very small amount of air (0.04sccm, corresponding to a leakage of 1mtorr/min) is introduced into the chamber a different emission spectrum 410 is obtained. The spectrum 410 has a very high emission peak around 388nm. The pattern of the emission spectrum 410 derives from the presence of the compound CN (generated from the reaction of nitrogen with the host plasma). On the other hand, the intensity of the C₂ emission peak is substantially unchanged.

The sensibility of the method described above is several orders of magnitude greater than the one of the methods known in the art, wherein the emission spectrum is monitored for the presence of a constituent of the air. Referring to Figure 4b, an emission spectrum obtained from a plasma with substantially no leak of air is denoted with 415; in the example shown in the figure, the plasma is obtained from 150sccm of HBr + 30sccm of Cl₂. If a substantial amount of air (such as 5sccm) is introduced into the chamber a different emission spectrum 420 is generated. In this case, although the amount of air introduced into the chamber is very high the difference between the two emission spectra 415 and 420 is almost imperceptible.

Similar considerations apply if an equivalent method is performed, if the execution of the jobs is controlled in another way, if an equivalent cleaning process is used, if the threshold value is different, if an equivalent alarm is actuated (for example, displaying a warning message on the monitor); alternatively, a different constituent of the host plasma is detected (such as Ar, CF₂ or F), the results of the test are not logged, or no alarm is activated (simply logging an indication of the leak of air when the reactor is completely unattended). Moreover, in a different embodiment of the invention, only the CN and C₂ emission peaks are detected (instead of the full emission spectrum), the absolute intensity of the CN emission peak is compared with the threshold value directly, or the verification of the leak of air is scheduled in a different manner; for example, the test is carried out periodically (such as 3 or 4 times every day), after each process step has been completed, after each wafer has been removed from the chamber, after a predetermined number of batches have been processed, and the like.

More generally, the present invention proposes a method of detecting a leak of external air into a plasma reactor. The method starts with the step of establishing a plasma inside the reactor; the plasma has a composition suitable to generate one or more predetermined compounds when reacting with the air. A light emission of the plasma is then detected. The light emission is analyzed to identify the presence of the predetermined compound.

The test implementing the method according to the present invention is very fast to execute. The reactor can then be tested whenever it is necessary; as a consequence, any leak of air is detected as soon as possible.

The test does not require the reactor to be idle, and it can be carried out without stopping the production flow. Therefore, the proposed solution does not affect the throughput of the reactor.

The method of the present invention is very simple, and it is suitable to be fully automated.

Nevertheless, the devised solution is extremely accurate; therefore, the proposed method makes it possible to detect the leakage of even a very small amount of air.

This advantage is more apparent when the reactor is used in high precision processes (although different applications are not excluded).

The preferred embodiment of the invention described above offers further advantages.

Particularly, the host plasma is generated from a gas including a fluorocarbon constituent.

In this case, air-based compounds with high intensity of the characteristic emission peaks are formed very easily when the host plasma reacts with the air.

Advantageously, the fluorocarbon constituent is CF₄.

The proposed composition of the host plasma further facilitates the generation of the air-based compounds in several applications.

Similar advantages have also been experienced generating the host plasma from a gas including a hydrocarbon constituent, and particularly CH₄.

A way to improve the method of the invention is to generate the host plasma with a pressure in the range from 50mtorr to 110mtorr, and a source power in the range from 400W to 600W.

These parameters have been found to maximize the intensity of the emission peaks characteristic of the air-based compounds.

In a preferred embodiment of the invention, the emission spectrum is analyzed to identify the presence of an air-based compound resulting from the reaction of nitrogen with the host plasma.

Experimental results have shown that the nitrogen-based compound features a very high intensity of the characteristic emission peak.

As a further enhancement, the nitrogen-based compound is CN.

The selected compound maximizes the sensibility of the proposed method.

However, the solution according to the present invention leads itself to be implemented using a host plasma with another composition (such as including CHF₃ or CH₂F₂), setting the operative parameters of the reactor to different values, detecting the presence of one or more alternative compounds, even resulting from the reaction of the host plasma with a different constituent of the air (such as oxygen or carbon); for example, alternative nitrogen-based compounds include CN+, CN₂, C₂N, C₂N₂, HCN, CHNS, NCO, NBr, NCl, NF₂, NH, NH+, NS, NSe or NSF, whereas oxygen-based compounds include OH, OH+, SO, FeO, ClO, ClO₂, CoS, CO+ or CHO.

Preferably, the reactor is cleaned before establishing the host plasma.

This additional step ensures that the air-based compound cannot be generated from the reaction of the host plasma with possible residues of previous process steps (without any leak of air).

However, the step of cleaning the reactor is not strictly necessary; for example, this step is not required when the previous process steps are particularly clean (such as when they do not involve the etching of any resist layer).

Advantageously, the solution according to the present invention is implemented with a computer program, which is provided as a corresponding product stored on a suitable medium.

Alternatively, the program is pre-loaded on the computer, is sent to the computer through a network, or more generally is provided in any other form directly loadable into a working memory of the computer; however, the method according to the present invention leads itself to be carried out even with a hardware structure (for example, integrated in a chip of semiconductor material).

Moreover, it should be noted that the apparatus for implementing the method of the invention is suitable to be put on the market as a stand-alone product, in order to be integrated with pre-existing plasma reactors.

Naturally, in order to satisfy local and specific requirements, a person skilled in the art may apply to the solution described above many modifications and alterations all of which, however, are included within the scope of protection of the invention as defined by the following claims.

## Claims

1. A method (300) of detecting a leak of external air into a plasma reactor including the steps of:
establishing (340) a plasma inside the reactor, the plasma having a composition suitable to generate at least one predetermined compound when reacting with the air, detecting (345) a light emission of the plasma, and
analyzing (350-375) the light emission to identify the presence of the at least one predetermined compound.

2. The method (300) according to claim 1, wherein the step of establishing (340) the plasma inside the reactor includes providing a flow of a gas including a fluorocarbon constituent.

3. The method (300) according to claim 2, wherein the fluorocarbon constituent is CF₄.

4. The method (300) according to claim 1, wherein the step of establishing (340) the plasma inside the reactor includes providing a flow of a gas including a hydrocarbon constituent.

5. The method (300) according to claim 4, wherein the hydrocarbon constituent is CH₄.

6. The method (300) according to any claim from 2 to 5, wherein the step of establishing (340) the plasma inside the reactor further includes:
keeping the gas at a pressure in the range from 50mtorr to 110mtorr, and
applying a source power in the range from 400W to 600W.

7. The method (300) according to any claim from 2 to 6, wherein the air includes nitrogen, the at least one predetermined compound resulting from the reaction of nitrogen with the plasma.

8. The method (300) according to claim 7, wherein the at least one predetermined compound is CN.

9. The method (300) according to any claim from 1 to 8, further including the steps before establishing (340) the plasma inside the reactor of:
processing (310-320) at least one wafer of semiconductor material,
removing (325) the at least one wafer from the reactor, and
cleaning (327) the reactor.

10. A computer program (260) directly loadable into a working memory (220) of a data processing system (160) for performing the method (300) of any claim from 1 to 9 when the program is run on the data processing system.

11. A program product (235) comprising a computer readable medium on which the program (260) of claim 10 is stored.

12. An apparatus (120-125,145-160) for detecting a leak of external air into a plasma reactor (105) including means (120-125) for establishing a plasma (130) inside the reactor, the plasma having a composition suitable to generate at least one predetermined compound when reacting with the air, means (145-155) for detecting a light emission of the plasma, and means (160) for analyzing the light emission to identify the presence of the at least one predetermined compound.

13. A system (100) including a plasma reactor (105) and the apparatus (120-125,145-160) according to claim 12 for detecting a leak of external air into the reactor.
